# EUROPEAN PATENT SPECIFICATION

(11) **EP 0 594 644 B1**
(45) Date of publication and mention of the grant of the patent: **12.03.1997**
(21) Application number: 92912744.7
(22) Date of filing: 27.05.1992
(51) Int. Cl.: C09J 163/00, C08G 73/06, H01B 1/22, C08G 59/40

(54) **ANISOTROPIC CONDUCTIVE ADHESIVE FILM**
ANISOTROPISCH LEITENDE KLEBEFOLIE
FILM ADHESIF CONDUCTEUR ANISOTROPE

(30) Priority: 12.07.1991 US 729082
(43) Date of publication of application: 04.05.1994
(73) Proprietor: MINNESOTA MINING AND MANUFACTURING COMPANY, St. Paul, Minnesota 55133-3427 (US)
(72) Inventor: EMORI, Kenji, Saint Paul, MN 55133-3427 (US); TASAKA, Yoshihiko, Saint Paul, MN 55133-3427 (US)
(74) Representative: Baillie, Iain Cameron
(86) International application number: PCT/US92/04411
(87) International publication number: WO 93/01248

(56) References cited:
- EP-A- 0 242 025
- EP-A- 0 266 986
- DE-A- 3 423 385

## Description

### Background of the Invention

### Field of the Invention

The present invention relates to an anisotropic adhesive composition, and Z-axis adhesive film formed therefrom.

### Description of the Related Art

Recently, with the development of high-density mounting and improved techniques in making electrical components, electrical circuits have become smaller and have higher connection densities. For bonding these precise and fine-pitch circuits, conductive adhesives have been frequently used. Ideally, a conductive adhesive is provided as a self-supporting film. Liquid systems, such as prior art epoxies will migrate due to capillary action and may touch or contaminate a critical area of the circuit. Anisotropic conductive films, also known as Z-axis films have been proposed. One advantage is that ZAFs provide pressure-engaged connections. Therefore, excellent resistance stability, high peel adhesion, and high insulative resistivity are needed for the ZAF. Also, to improve the productivity, a very short bonding time and low bonding temperature such as 180°C for 20 seconds are required. Moreover, with the progress of circuits, the alignment has become more difficult and the number of connection failures has also increased. So repairability is essential; repairability is defined as the ease by which the substrate is cleaned with normal solvents.

As disclosed in JPP1987-181379 and JPP1988-86781 (A), styrene-butadiene-styrene block copolymers (SBS) and styrene-ethylene-butylene-styrene clock copolymers (SEBS) are used. These thermoplastic resins have good repairability, but poor heat and humidity resistance. Further, the resins are high molecular weight, and have a high melt viscosity. The resistance stability tends to become worse and there is a limitation in that comparatively large size conductive particles are required.

Epoxy thermoset adhesives have also been proposed; however, they are not repairable. Further, the curing speed is short, the shelf life is short, and the mixing of resin and hardeners are sometimes ineffective.

Z-axis films using cyanate films exhibit fast curing, good heat resistance, excellent resistance stability and repairability. However, cyanate esters may also easily absorb moisture, and the peel adhesion may decrease after humidity aging.

Combinations of cyanate esters and epoxy resins are disclosed in U.S. Patent No. 3,562,214. However, the addition of epoxy resins to cyanate esters remarkably decreases the heat resistance temperature. Also film-formability is significantly impaired.

It has now been discovered that certain combination of an epoxy, a cyanate ester, and a film-formable thermoplastic resin provide a z-axis film with a rapid curing speed, good heat resistance, good humidity resistance, long shelf life and excellent repairability.

### Summary of the Invention

The present invention provides a composition for the formation of an anisotropically conductive adhesive film which provides good adhesive properties, excellent repairability, and good heat resistance.

Anisotropically conductive adhesives of the invention comprise:
(a) an adhesive composition comprising about 100 parts cyanate, 0.01 to 10 parts catalyst, from 10 to 300 parts film formable thermoplastic resin and from 10 to 500 parts epoxy resin; and
(2) from 0.1 to 20 parts conductive particles per 100 parts total weight of the adhesive composition.

The present invention further provides an anisotropic film formed from the composition.

As used herein, the terms "Z-axis film" and "ZAF" are used interchangeably to mean an adhesive film having conductivity in the direction of the "Z" axis.

### Detailed Description of the Invention

Compositions of the invention contain cyanate esters as major components. These resins have good heat and humidity resistance and are capable of rapid curing with certain self-crosslinking catalysts.

Cyanate ester resins comprise cyanate ester compounds (monomers and oligomer) each having two or more -OCN functional groups, and typically having a cyanate equivalent weight of from 50 to 500, preferably from 50 to 250. The molecular weight of the monomers and oligomers are typically from 150 to 2000. If the molecular weight is too low, the cyanate ester has a crystalline structure which is difficult to dissolve in solvent. If the molecular weight is too high, the compatibility of the cyanate ester with other resins is poor.

Preferred compositions of the invention include one or more cyanate esters according to Formulas I, II, III or IV. Formula I is represented by

Q(OCN)ₚ Formula I

wherein p can be from 2 to 7, and wherein Q comprises at least one of the following categories: (1) a mono-, di-, tri-, or tetra-substituted aromatic hydrocarbon containing from 5 to 30 carbon atoms, (2) a 1 to 5 aliphatic or polycyclic aliphatic mono-, di-, tri-or tetra- substituted hydrocarbon containing from 7 to 20 carbon atoms. Optionally, either category may contain from 1 to 10 heteroatoms selected from the group consisting of non-peroxidic oxygen, sulfur, non-phosphino phosphorous, non-amino nitrogen, halogen, and silicon. Formula II is represented by 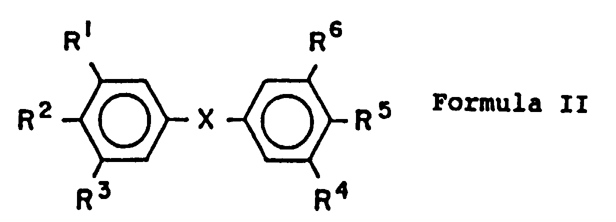 where X is a single bond, a lower alkylene group having from 1 to 4 carbons, -S-, or the SO₂ group; and where R¹, R¹, R³, R⁴, R⁵, and R⁶ are independently hydrogen, an alkyl group having from one to three carbon atoms, or the cyanate ester group (-OC≡N), with the proviso that at least two of R¹, R², R³, R⁴, R⁵, and R⁶ are cyanate ester groups. In preferred compounds, each of the R groups is either -H, methyl or the cyanate ester group.

Formula III is represented by 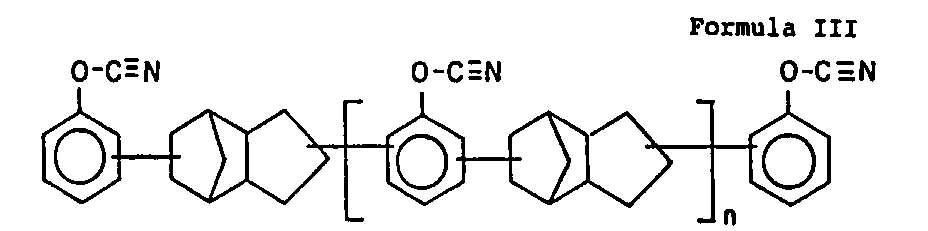 where n is from 0 to about 5.

Formula IV is represented by 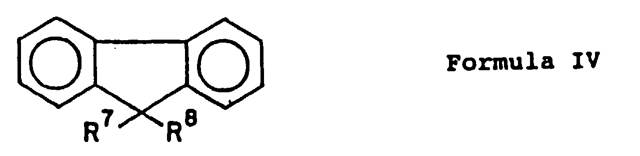 wherein R⁷ and R⁸ are independently 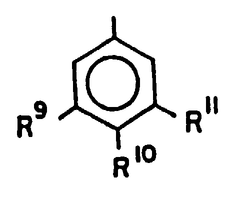 wherein R⁹, R¹⁰, R¹¹ are independently -H, a lower alkyl group having from 1 to 5 carbon atoms, or the cyanate ester group, preferably hydrogen, methyl or the cyanate ester group, with the proviso that R⁷, and R⁸ combined include at least two cyanate ester groups.

Useful cyanate ester compounds include, but are not limited to the following:
1,3- and 1,4-dicyanobenzene;
2-tert-butyl-1,4-dicyanobenzene;
2,4-dimethyl-1,3-dicyanobenzene;
2,5-di-tert-butyl-1,4-dicyanobenzene;
tetramethyl-1,4-dicyanobenzene;
4-chloro-1,3-dicyanobenzene;
1,3,5-tricyanobenzene;
2,2'- and 4,4'-dicyanobiphenyl;
3,3'5,5'-tetramethyl-4,4'-dicyanobiphenyl;
1,3-, 1,4-, 1,5-, 1,6-, 1,8-, 2,6-, and 2,7-dicyanonaphthalene;
1,3,6-tricyanonaphthalene;
bis(4-cyanophenyl)methane;
bis(3-chloro-4-cyanophenyl)methane;
bis(3,5-dimethyl-4-cyanophenyl)methane;
1,1-bis(4-cyanophenyl)ethane;
2,2-bis(4-cyanophenyl)propane;
2,2-bis(3,3-dibromo-4-cyanophenyl)propane;
2,2-bis(4-cyanophenyl)-1,1,1,3,3,3-hexafluoropropane;
bis(4-cyanophenyl)ester;
bis(4-cyanophenoxy)benzene;
bis(4-cyanophenyl)ketone;
bis(4-cyanophenyl)thioether;
bis(4-cyanophenyl)sulfone;
tris(4-cyanophenyl)phosphate, and
tris(4-cyanophenyl)phosphate.

Also useful are cyanic acid esters derived from phenolic resins, e.g., as disclosed in U.S. Patent 3,963,184, cyanated novolac resins derived from novolac, e.g., as disclosed in U.S. Patent No. 4,022,755, cyanated bis-phenol-type polycarbonate oligomers derived from bisphenol-type polycarbonate oligomers, as disclosed in U.S. Patent 4,096,913, cyano-terminated polyarylene ethers as disclosed in U.S. Patent No. 3,595,000, and dicyanate esters free of ortho hydrogen atoms as disclosed in U.S. Patent No. 4,740,584, mixtures of di-and tricyanates as disclosed in U.S. Patent No. 4,709,008, polyaromatic cyanates containing polycyclic aliphatic groups as disclosed in U.S. Patent No. 4,528,266, e.g., QUARTEX™ 7187, available from Dow Chemical, fluorocarbon cyanates as disclosed in U.S. Patent No. 3,733,349, and cyanates disclosed in U.S. Patents 4,195,132, and 4,116,946, all of the foregoing patents being incorporated by reference.

Polycyanate compounds obtained by reacting a phenolformaldehyde precondensate with a halogenated cyanide are also useful.

Examples of preferred cyanate ester compositions include low molecular weight oligomers, e.g., from 250 to 1200, of bisphenol-A dicyanates such as AroCy UC-30 Cyanate Ester Semisolid Resin, commercially available from Hi-Tex polymers, Jeffersontown, Kentucky; low molecular weight oligomers of tetra o-methyl bisphenol F dicyanates, such as AroCy M-30 Cyanate Ester Semisolid Resin, also commercially available from Hi-Tek Polymers; low molecular weight oligomers of thiodiphenol dycyanated, such as AroCy T-30 Cy.

Known curing catalysts are useful in compositions of the invention. An organometallic compound, metal chelate or an organometallic salt are suitable candidates. An organometallic is defined as a compound which has at least one carbon directly connected to a metal atom. Metal chelate compounds are defined as those compounds having a ligand over 1-6 and such catalysts as acetylacetonate copper. These catalysts are activated by both heat and light, and therefore exposure to heat can shorten the curing time even more. They are easily dissolved and dispersed in the adhesive solution.

Catalysts for the reaction of the cyanate ester include organometallic compounds containing a cyclopentadienyl group, C₅H₅, and suitable derivatives, such as cyclopentadienyl iron dicarbonyl dimer, [C₅H₅Fe(CO)₂]₂, pentamethylcyclopentadienyl iron dicarbonyl dimer, [C₅(CH₃)₅Fe(CO₂)₂, methylcyclopentadienyl manganesetricarbonyl, all available from Strem Chemical Company, Newburyport, Massachusetts, and hexafluorophosphate salt of the cyclopentadientyl iron mesitylene cation, C₅H₅ (mesitylene)Fe⁺PF₆-, and trifluoromethanesulfonate salt of the cyclopentadienyl iron mesitylene cation, C₅H₅ (mesitylene)Fe⁺CF₃SO₃ ⁻, both of which may be-prepared as described in U.S. Patent 4,868,277, incorporated herein by reference.

Other organometallic compounds which are suitable catalysts for use in the present invention are disclosed in EPO Publication No. 364,073. Suitable sources of radiation for photoactivation of the catalysts include such conventional sources as mercury vapor discharge lamps, tungston lamps, xenon lamps, fluorescent lamps, sunlamps, lasers, carbon arcs, and sunlight. Photoactivated catalysts are preferred as they increase shelf life.

Useful film-formable thermoplastics are those having good compatibility with cyanate ester and a group reactive to epoxy. Included in this class are polyvinylbutyral, polyvinylformyl, polyvinylacetal, polyamide, phenoxy, polysulfone, polycarbonate siloxane, polyvinyl, epoxy acrylate, glycidyl acrylate, carboxylated SEBS, epoxylated SEBS and the like. Preferred thermoplastics are those having molecular weights between 3,000 and 200,000. If the molecular weight is below about 3000, the resin has a poor film-forming ability; if the molecular weight is over 200,000, the thermoplastic and the cyanate ester will not mix adequately, and the curing time is significantly extended.

Suitable polysulfones include those having the general formula: 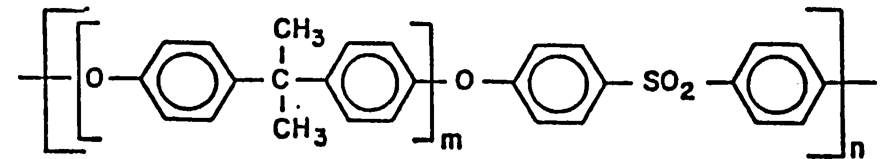 wherein m is 0 or 1, and n is 10 to 500. When m is 0, n is preferably from 12 to 50, and when m is 1, n is preferably from 40 to 70.

Examples of suitable polysulfones include "P1700-NT11", commercially available from Amoco Performance Products, Ridgefield, CT; and "Victrex PES 5003P", commercially available from ICI Advanced materials, Wilmington, DE.

Suitable polyvinyl acetals are those having the general formula: 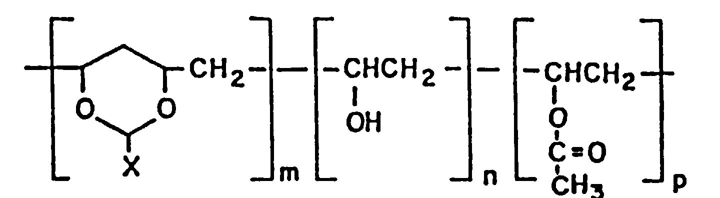 wherein X is -H or a C₁-C₄ alkyl group, and m is from 80 to 2400, n is from 10 to 2200, and p is from 0 to about 500. Preferably, m is greater than n, n is greater than p, m is less than 800, and each monomer is randomly distributed.

Suitable phenoxy resins have the following general formula: 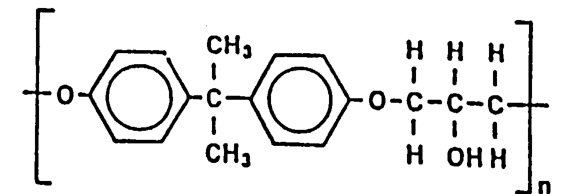 wherein n is 75 to 150.

Useful phenoxy resins include "UCAR" resins, available in three molecular weight grades ranging from 25,000 to 35,000, from Union Carbide Company, Danbury, CT.

Examples of useful polyvinylacetals include polyvinylbutryals, such as Sekisui S-LEC BX-L.

Examples of useful polyamides include Unires 2636, commercially available from Union Camp, Jacksonville, FL.

Examples of polyesters include Dynapol 206, commercially available from HULS America, Inc. One useful polycarbonatesiloxane is LR3320, from General Electric, Schnectady, NY. Examples of polyvinylics include polystyrene, polyacrylates, and polymethacrylates.

An epoxy resin is defined as a resin having more than one epoxy group. Preferably, conventional epoxy resins having from 150 to 400 epoxy equivalents may be used. The epoxy resin comprises from 10 to 500 parts by weight per 100 parts of cyanate ester. If the epoxy content is below 10 parts, the heat and humidity resistance is only slightly improved. If the content is over 500 parts by weight, there is unreacted epoxy resin left and initial peel adhesion decreases.

Known conductive materials can be chosen from such as metal particles, coagulated metal particles, solder particles, and conductive particles having a polymer core thin metal surface layer. Compositions of the invention contain from 0.1 part to 20 parts by weight of the conductive material to 100 parts by total adhesive weight. If the conductive material content is below 0.1 part, resistance stability decreases. If the content is above 20 parts, there is a high possibility of short circuit.

The invention can further comprise other thermosetting resins such as phenolic and silicone resins, epoxy hardeners, tackifiers, coupling agents, antioxidants, modifiers and additives without departing from the spirit of the invention.

All percents, parts and ratios herein are by weight unless specifically stated otherwise. The following examples are meant to be illustrative and do not limit the scope of the invention, which is defined solely by the claims.

### EXAMPLES

### EXAMPLE 1

### (1) Preparation of the adhesive

100 g of "Arocy B10" (2,2-bis(4-cyanophenyl) propane), having a molecular weight (Mw) of 270, available from Hi-Tek, was used as the cyanate ester and 100 g of "Eslec BX-1" a polyvinyl-butyral (PVB), having a Mw of 100,000, available from Sekisui Chemical was used as a film-formable thermoplastic resin. They were dissolved into 200 g of MEK, "Quatrex 1010", a DGEBA type epoxy with an epoxy equivalent weight of 186, available from Dow Chemical Co.), along with 0.5 g of cyclopentadinyel-Fe-dicarbonyl dimer ((C₅H₅.Fe(CO)₂))₂/iron dicarbony/dimer (ICD) as a curing catalyst and 15 g of Finepear™ Au-10s (Au plated polymer particle, average dia. 10µ, Sumitomo chem.) were added to the solution. The solution was then applied on a releasing polyester film (thickness 50µ) with a hand applicator and dried in the oven.

Thus the ZAF with a thickness of 23µ was obtained.

### (2) Resistance and peel adhesion test

Commercial gold (Au) plated Copper/polymide film printed circuit (pitch=0.2 mm, conductor width=0.1mm) (FPC) and ITO glass (arc resistivity=30 ohm/sq) was bonded at 180°C and 30Kg/cm² pressure for 20 seconds. Resistance and peel adhesion were measured respectively by a multimeter and a tensiometer before and after humidity aging for 250 hours at 85°C and 85% RH.

### (3) Short circuit

The above FPC and an insulative glass were bonded at 180°C and 30Kg/cm² pressure for 20 seconds. The insulative resistance between 200 adjacent conductors was measured by a multimeter.

### (4) TGA

The ZAF was cured at 180°C for 30 minutes in the oven. After that, 5 wt% weight loss temperature was measured by TGA951 (Dupont).

### (5) Tg

Tg was measured by DSC4 (Perkin Elmer).

### (6) Curing speed 1

Curing speed was estimated from DSC peak temperature.

### (7) Curing speed 2

Curing speed was estimated from tack free time (TFT) by a plate gelling timer. TFT is the time until there is no remaining tack on the surface of the sample.

### (8) Shelf life

Shelf life was studied from the viewpoint of flexibility of the ZAF film, and is defined as the time until a crack is produced when the film is bent at 180°.

### (9) Repairability

An FPC and an ITO glass were bonded at 180°C for 30Kg/cm² pressure for 20 seconds. After peeling off the FPC, the time until the adhesive resdue was cleaned with acetone was measured.

### EXAMPLES 2 TO 14

In examples 2-14, various types and amounts of cyanate esters, catalysts, and epoxy resins were tested. The preparation of the ZAF and the measurement method were the same as Example 1. The resins used were as follows:

### Cyanate Ester Resin

AROCY B10 (2,2-bis(4-cyanophenyl)propane, Mw=270, Hi-Tek)
AROCY B30 (2,2-bis(4-cyanophenyl)propane, Mw=560, Hi-Tek)
AROCY B50 (2,2-bis(4-cyanophenyl)propane, Mw=1100, Hi-Tek)
AROCY M30 bis(3,5-dimethyl) (4-cyanophenyl)methane, Mw=490, Hi-Tek)
QUATREX XU71787 (cycloaliphatic cyanate ester, Dow chem.)

### Catalyst

Co naphthenate, Cu naphthenate, Cu acetylacetonate, Mn2(co)10,IDC

### Thermoplastic

UCAR PKHC (phenoxy, Mw=25000, UCC)
UCAR PKHH (PVB, Mw=35000, UCC)
ESLEC BX-5 (PVB, Mw=150000, Sekisui chem.)
ESLEC BXL (PVB, Mw=18000, Sekisui chem.)
FORMVAR 7/95s (polyvinylformaar, Mw=18000, Monsanto)
TAFUTEC M1913 (calboxylated SEBS, Mw=50000, Asahi chem.)

### Epoxy resin

QUATREX1010 (DGEBA type epoxy, EEW=186, Dow chem.)
EPIKOTE 152 (Novolac liquid epoxy, EEW=175, Shell Chemical Co.)
EPOTOHTO YR102 (rubber modified epoxy, EEW=1200, Tokyo Chemical Co.)
ERL 4221 (cycloaliphatic epoxy, EEW=137, UCC)

### Conductive Material

Finepearl Au10s (Au plated polymer particle, Ave. diameter 10µ, Sumitomo Chemical Co.)
T123 (Carbon Ni, Ave. dia. 4µ, Inco)
SF-PbSn6040 (Superfine solder powder, Ave. dia. 10µ, Nippon Atomize)
The results are shown in Table 1. The resins used in Examples 1 through 14 are as follows:

| EX. | CYANATE | CATALYST | THERMO PLASTICS | EPOXY | PARTICLE |
|---|---|---|---|---|---|
| 1 | B10/100 | IDC/1.0 | BX1/100 | 1010/100 | AU10s15 |
| 2 | B30/100 | IDC/0.1 | BXL/50 | 1010/10 | AU10S/8 |
| 3 | B30/100 | IDC/3.0 | BXL/200 | 1010/30 | AU10s/9 |
| 4 | B30/100 | IDC/5.0 | BXL/300 | 1010/50 | AU10s/15 |
| 5 | B10/100 | IDC/1.0 | BX1/100 | 152/300 | AU10S/50 |
| 6 | B10/100 | IDC/1.0 | BX1/100 | 152/500 | AU10s/9 |
| 7 | B50/100 | IDC/0.01 | PKHC/50 | YR102/100 | AU10s/15 |
| 8 | B10/100 | AcAcCu/0.5 | M1913/20 | YR102/30 | AU10S/8 |
| 9 | XU/100 | AcAcCu/10 | 7/95S/30 | YR102/200 | AU10s/9 |
| 10 | XU/100 | Mn₂(CO)10/2.C | BX5/10 | ERL4221/50 | AU10s/15 |
| 11 | XU/100 | CoNp/1.0 | PKHH/50 | ERL4221/75 | AU10S/8 |
| 12 | B10/100 | CuNp/1.0 | BXL/150 | 1010/10 | AU10s/9 |
| 13 | B10/100 | IDC/3.01 | BX1/200 | 1010/50 | AU10S/8 |
| 14 | B50/100 | IDC/3.0 | PKHH/100 | 152/100 | AU10s/9 |

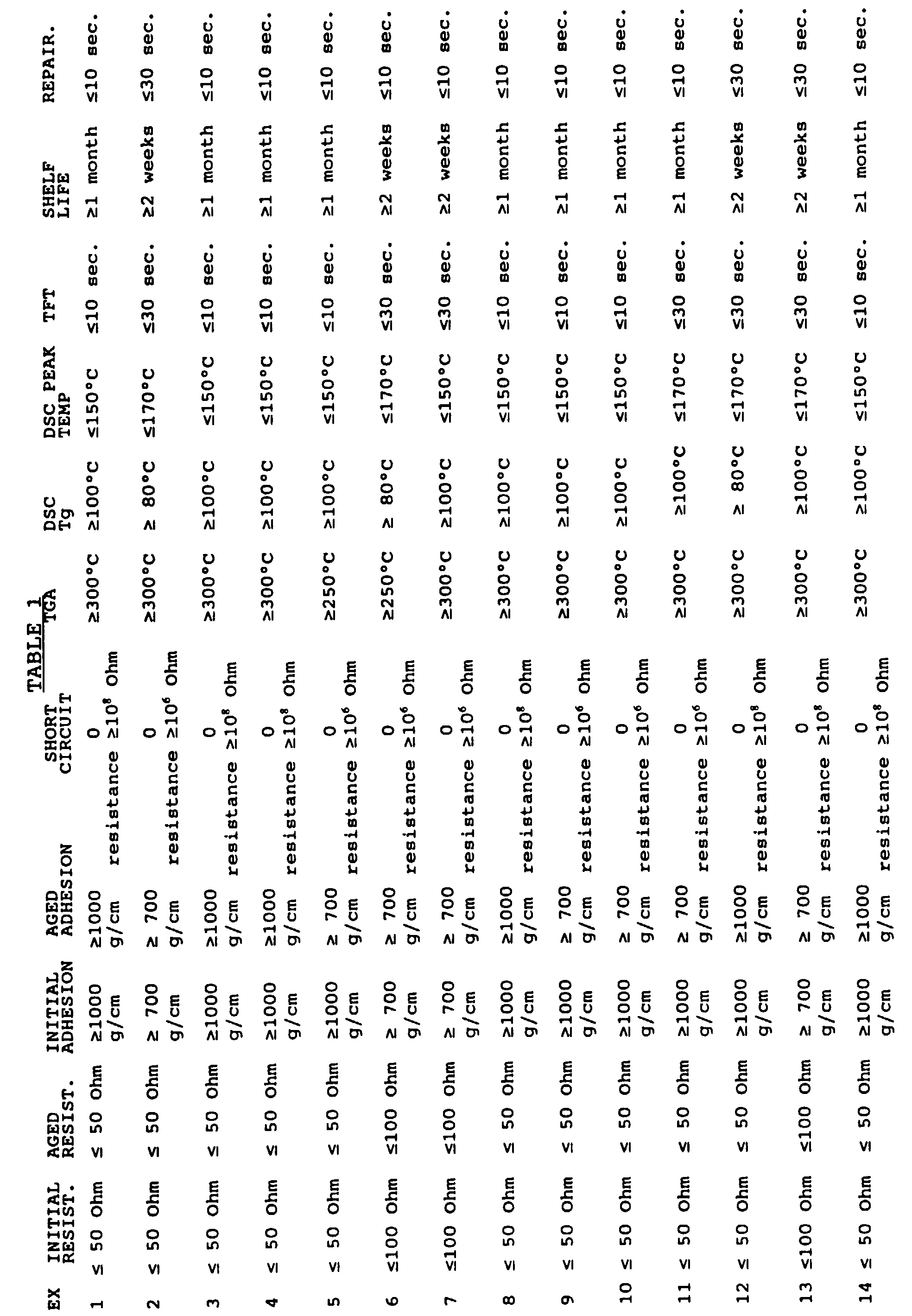

### COMPARATIVE EXAMPLES 1-6

These Comparative Examples are examples outside the scope of this invention. Comparative Example 5 is an example using G1650 (SEBS, Shell Chem.) a thermoplastic resin which does not have a reactive group for an epoxy resin. The test results are shown in Table 2. The resins used in comparative examples 1 through 6 are as follows:

| EX. | CYANATE | CATALYST | THERMO PLASTICS | EPOXY | PARTICLE |
|---|---|---|---|---|---|
| 1 | 310/100 | IDC/0.005 | BX1/400 | 0 | AU10s/2.5 |
| 2 | B30/100 | IDC/20 | BXL/5 | 152/50 | AU10s/1.0 |
| 3 | B30/100 | IDC/1.0 | PKHC/100 | 1010/800 | T123/10.0 |
| 4 | XU/100 | AcAcCu/1 | PKHC/50 | 1010/300 | T123/0.1 |
| 5 | XU/100 | AcAcCo/15 | BXL/50 | 152/5 | T123/0.1 |
| 6 | XU/100 | IDC/5 | G165C/300 | 152/10 | AU10s/10.0 |

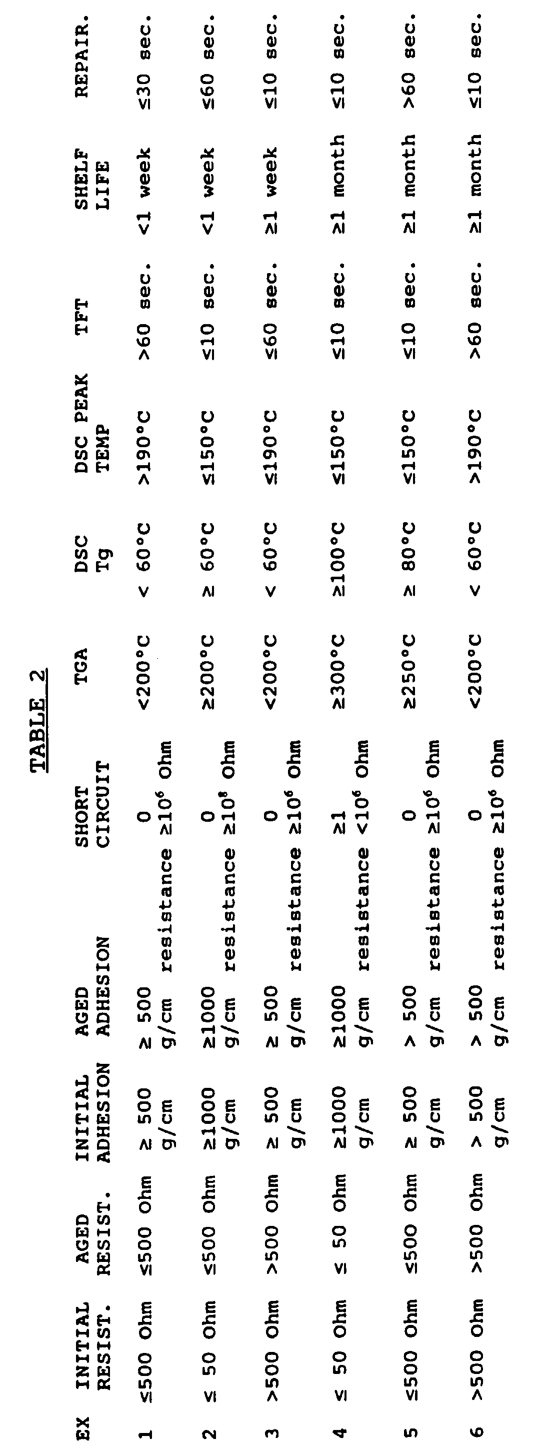

## Claims

1. An anisotropically conductive adhesive comprising:
(a) an adhesive composition comprising about 100 parts of cyanate ester, from 0.01 to 10 parts of a catalyst, from 10 to 300 parts of a film formable thermoplastic resin, and from 10 to 500 parts of an epoxy resin; and
(b) from 0.1 to 20 parts conductive particles per 100 parts total weight of said adhesive.

2. The anisotropically conductive adhesive of claim 1, wherein said catalyst is selected from the group consisting of organometallic compounds, metal chelates and organometallic salts.

3. The adhesive of any preceding claim wherein said film formable thermoplastic resin is selected from the group consisting of polyvinylbutyral, polyvinylformal, polyvinylacetal, polyamide, phenoxy, polysulfone, polyacrylate, glycidyl acrylate, styrene-butadiene-styrene block copolymers, carboxylic styrene-ethylene-butylene-styrene block copolymers, and epoxylic styrene-ethylene-butylene-styrene block copolymers.

4. The adhesive of claim 3 wherein the film formable thermoplastic resin has a molecular weight of from 3,000 to 200,000.

5. The adhesive of any preceding claim wherein the cyanate ester is selected from the group consisting of:
2,2-bis(4-cyanophenyl)propane, 2,2-bis(4-cyanophenyl)propane, 2,2-bis(4-cyanophenyl)propane, bis(3,5-dimethyl)(4-cyanophenyl)methane, and cycloaliphatic cyanate ester.

6. The anisotropically conductive adhesive of any preceding claim wherein said conductive particle are selected from the group consisting of metal particles, coagulated metal particles, solder particles, and conductive particles having a polymer core and a thin metal surface layer.

## Patentansprüche

1. Anisotrop leitfähiger Klebstoff, umfassend:
(a) eine Klebstoffzusammensetzung mit etwa 100 Teilen Cyanatester, 0,01 ... 10 Teilen Katalysator, 10 ... 300 Teilen filmbildendem thermoplastischem Harz und 10 ... 500 Epoxyharz;
(b) 0,01 ... 20 Teile leitfähige Partikel pro 100 Teile Gesamtmasse des Klebstoffes.

2. Anisotrop leitfähiger Klebstoff nach Anspruch 1, bei welchem der Katalysator ausgewählt wird aus der Gruppe, bestehend aus metallorganischen Verbindungen, Metallchelaten und metallorganischen Salzen.

3. Klebstoff nach einem der vorgenannte Ansprüche, bei welchem das filmbildende thermoplastische Harz ausgewählt wird aus der Gruppe, bestehend aus: Polyvinylbutyral, Polyvinylformal, Polyvinylacetal, Polyamid, Phenoxyharz, Polysulfon, Polyacrylat, Glycidylacrylat, Butadien/Styrol-Blockcopolymeren, carboxylischen Styrol/Ethylen/Butylen/Styrol-Blockcopolymeren und epoxidischen Styrol/Ethylen/Butylen/Styrol-Blockcopolymeren.

4. Klebstoff nach Anspruch 3, bei welchem das filmbildende thermoplastische Harz eine Molmasse von 3.000 ... 200.000 hat.

5. Klebstoff nach einem der vorgenannte Ansprüche, bei welchem der Cyanatester ausgewählt wird aus der Gruppe, bestehend aus 2,2-Bis(4-cyanophenyl)propan, 2,2-Bis(4-cyanophenyl)propan, 2,2-Bis(4-cyanophenyl)propan, Bis(3,5-dimethyl)(4-cyanophenyl)methan sowie cycloaliphatischer Cyanatester.

6. Anisotrop leitfähiger Klebstoff nach einem der vorgenannte Ansprüche, bei welchem die leitfähigen Partikel ausgewählt werden aus der Gruppe, bestehend aus Metallpartikeln, koagulierten Metallpartikeln, Lotpartikeln und leitfähigen Partikeln mit einem Polymerkern und einem dünnen Metallüberzug.

## Revendications

1. Adhésif anisotropiquement conducteur comprenant:
(a) une composition adhésive comprenant environ 100 parties d'ester cyanate, de 0,01 à 10 parties d'un catalyseur, de 10 à 300 parties d'une résine thermoplastique filmogène, et de 10 à 500 parties d'une résine époxy; et
(b) de 0,1 à 20 parties de particules conductrices pour 100 parties de poids total dudit adhésif.

2. Adhésif anisotropiquement conducteur selon la revendication 1, dans lequel ledit catalyseur est choisi dans le groupe formé par les composés organométalliques, les chélates de métal et les sels organométalliques.

3. Adhésif selon l'une quelconque des revendications précédentes, dans lequel ladite résine thermoplastique filmogène est choisie dans le groupe formé par le polyvinylbutyral, le polyvinylformal, le polyvinylacétal, le polyamide, le phénoxy, la polysulfone, le polyacrylate, l'acrylate de glycidyle, les copolymères séquencés styrène/butadiène/styrène, les copolymères séquencés styrène/éthylène/butylène/styrène carboxyliques et les copolymères séquencés styrène/éthylène/butylène/styrène époxyliques.

4. Adhésif selon la revendication 3, dans lequel la résine thermoplastique filmogène possède une masse moléculaire comprise entre 3 000 et 200 000.

5. Adhésif selon l'une quelconque des revendications précédentes, dans lequel l'ester cyanate est choisi dans le groupe formé par:
le 2,2-bis(4-cyanophényl)propane, le 2,2-bis(4-cyanophényl)propane, le 2,2-bis(4-cyanophényl)propane, le bis(3,5-diméthyl)(4-cyanophényl)méthane et l'ester cyanate cycloaliphatique.

6. Adhésif anisotropiquement conducteur selon l'une quelconque des revendications précédentes, dans lequel ladite particule conductrice est choisie dans le groupe formé par les particules métalliques, les particules métalliques coagulées, les particules de soudure et les particules conductrices ayant un noyau polymère et une couche superficielle mince de métal.
